(19) **Europäisches Patentamt**
**European Patent Office**
**Office européen des brevets**

(11) **EP 0 905 766 B1**

(12) **FASCICULE DE BREVET EUROPEEN**

(45) Date de publication et mention
de la délivrance du brevet:
**27.06.2007  Bulletin 2007/26**

(51) Int Cl.:
*H01L 21/66* (2006.01)          *H01L 23/525* (2006.01)
*G06F 11/20* (2006.01)

(21) Numéro de dépôt: **98410107.1**

(22) Date de dépôt: **24.09.1998**

(54) **Structure et procédé de réparation de circuits intégrés**

Struktur und Verfahren zum Reparieren einer integrierten Schaltung

Structure and method to repair integrated circuits

(84) Etats contractants désignés:
**DE FR GB IT**

(30) Priorité: **25.09.1997  FR 9712168**

(43) Date de publication de la demande:
**31.03.1999  Bulletin 1999/13**

(73) Titulaire: **STMicroelectronics S.A.**
**92120 Montrouge (FR)**

(72) Inventeur: **Chaisemartin, Philippe**
**38190 Saint Agnès (FR)**

(74) Mandataire: **de Beaumont, Michel**
**1, rue Champollion**
**38000 Grenoble (FR)**

(56) Documents cités:
**EP-A- 0 557 079          EP-A- 0 774 780**

**Description**

La présente invention concerne le domaine des circuits intégrés.

Les évolutions rapides de la technologie ont amené une augmentation de la complexité des circuits en même temps qu'une diminution du cycle de vie commercial des circuits. Par contre le temps requis par un cycle de fabrication (dessin des masques, traitement des plaquettes de silicium, test et encapsulation des circuits) reste toujours important.

Inévitablement, après la conception d'un circuit intégré complexe, il arrive fréquemment que les premiers circuits fabriqués présentent des erreurs. On peut alors refaire passer le circuit par les étapes de conception pour tenter de corriger l'erreur puis relancer un lot de fabrication. Ceci exige un nouveau cycle complet de fabrication ce qui est coûteux et long et peut remettre en cause l'intérêt commercial du circuit.

On préfère donc souvent corriger l'élément matériel constitué par le circuit intégré lui-même. Ceci dans le but de valider la correction sur quelques prototypes seulement. La correction sur des circuits produits en série ne pouvant se faire que par modification des masques. Un circuit intégré comprend de façon générale un substrat semiconducteur couramment en silicium dans lequel sont formés les divers composants élémentaires du circuit. Ce substrat est surmonté de plusieurs niveaux de couches conductrices (silicium polycristallin, métallisations, généralement englobées par le terme de "niveaux de métallisation"). Une fois qu'on a identifié un défaut du circuit intégré, tel qu'une fonction logique manquante, des machines de grande précision (MDL 1000 de Bertin/Spectra Physics pour la découpe laser, FIB (Focus Ion Beam) de Schlumberger pour la découpe et le perçage, le dépôt de métal et le dépôt d'oxyde) permettent de percer les niveaux de métallisation pour accéder aux bornes de composants élémentaires, pour déconnecter ces composants et pour reconnecter les entrées et les sorties de ces composants à une "cellule de secours" qui est destinée à rajouter la fonction logique manquante.

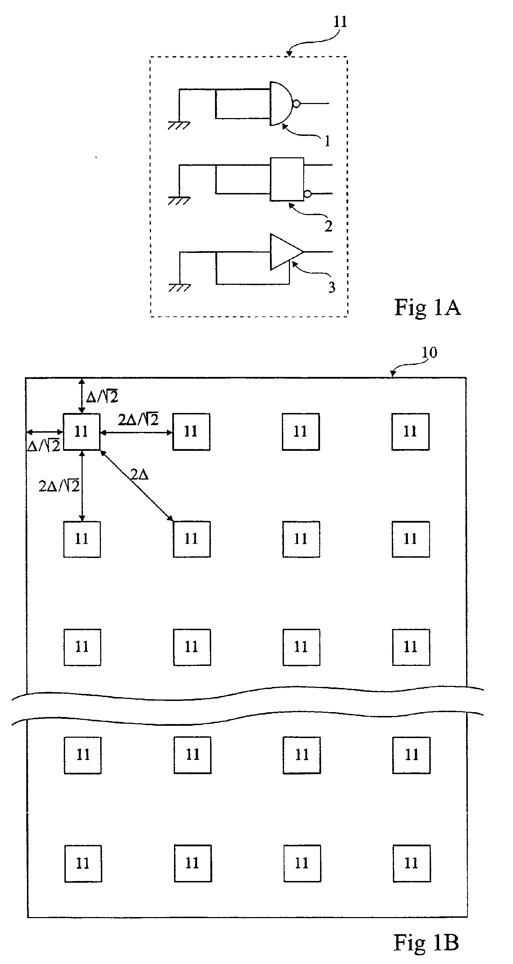

Ces cellules de secours n'ont aucune fonction dans le circuit tant que ce dernier ne doit pas être corrigé, leurs entrées sont classiquement connectées à la masse afin d'éviter une consommation de puissance inutile. On implante classiquement les cellules de secours par groupes. La figure 1A représente de manière schématique un groupe classique 11 de cellules de secours constitué d'une porte NON ET (1), d'une bascule D (2) et d'une porte trois états (3) afin de permettre une grande variété de corrections.

La figure 1B représente à titre d'exemple une vue de dessus extrêmement schématique d'un circuit intégré dont les composants de base n'ont pas été représentés. Dans ce circuit intégré 10, on implante un grand nombre de groupes de cellules de secours 11. Ce sont ces cellules qui, lors d'une réparation doivent être reliées à des points choisis du circuit. Ces cellules doivent être en grand nombre car une limitation du procédé de correction susmentionné est que les machines destinées à établir les connexions de remplacement (classiquement par implantation de métal à la surface du circuit) ne permettent pas, pour des raisons techniques, de réaliser des connexions de remplacement dépassant une certaine longueur ($\Delta$). Pour qu'un circuit puisse être éventuellement réparé en chacun de ses points, chacun de ses points ne doit pas être distant de plus de la longueur $\Delta$ d'un groupe de cellules de secours. Ainsi les groupes de cellules de secours 11 sont classiquement disposés selon des rangées et des colonnes distantes de $2\Delta/\sqrt{2}$ les unes des autres sur tout le circuit 10 que l'on veut rendre réparable. Egalement, les groupes de cellules peuvent être à une distance de $\Delta/\sqrt{2}$ des bords du circuit que l'on désire rendre réparable. Les cellules de secours, implantées parmi les composants de base du circuit, occupent une surface qui est loin d'être négligeable et accroissent la surface du circuit, et par là son coût.

Si l'on prend comme exemple un circuit tel que représenté en 1B, de 10 mm x 10 mm, $\Delta$ étant égal à 400 $\mu$m, le nombre de groupes de cellules de secours implanté sera de (10 000 x $\sqrt{2}$/400) x (10 000 x $\sqrt{2}$/400) = 10 000/8=1250. Si l'on considère qu'un groupe de cellules de secours est constitué d'environ quarante transistors, l'ensemble des groupes de cellules de secours dans ce mode de réalisation selon l'art antérieur représente 1 250 x 40 = 50 000 transistors. Une puce de 10 mm x 10 mm fait classiquement un million de transistors, les cellules de secours représentent dans ce cas là 5 % de la surface de la puce, ce qui va accroître de 5 % au moins le prix de la puce.

Afin de conserver des coûts raisonnables, on est en pratique tenté de réduire le nombre de groupes de cellules de secours, et de les placer seulement dans les zones du circuit les plus susceptibles de présenter des erreurs, mais on perd du même coup l'assurance de pouvoir effectuer une réparation en tout point du circuit, et on rencontre parfois des problèmes de réparation impossibles à réaliser.

Une autre limitation de cette méthode tient à ce que la coupure ou l'établissement d'une connexion amène à creuser les couches supérieures du circuit jusqu'à la connexion à couper, et jusqu'aux bornes de la cellule de secours que l'on veut connecter. Plus les éléments à atteindre sont profondément situés, plus l'opération de creusage et l'opération de connexion qui s'ensuivront seront délicates, longues et coûteuses.

Un objet de la présente invention est de pallier les inconvénients des méthodes de correction susmentionnées.

Un objet plus particulier de la présente invention est de réduire la surface de silicium occupée par les cellules de secours.

Un autre objet de la présente invention est de faciliter les opérations de réparation en réduisant les opérations de traversée de couches de métallisation.

Ces objets ainsi que d'autres sont atteints par un circuit intégré comprenant au moins un groupe de cellules de secours reliées à des pistes métalliques disposées sur le circuit afin que tout point du circuit soit distant de ces pistes d'au plus la valeur maximale Δ permise à une réparation de secours. Ainsi connecté, un seul groupe de cellules de secours suffit à garantir que l'on pourra effectuer au moins une réparation en tout point du circuit.

Selon un mode de réalisation de la présente invention, les pistes de secours sont réalisées dans un niveau métallique le plus proche possible de la surface du circuit, afin de faciliter une éventuelle réparation.

Plus particulièrement la présente invention prévoit un circuit intégré dont une portion au moins comprend au moins un groupe de cellules de secours destinées à être éventuellement reliées à ladite portion du circuit intégré après la fabrication de celui-ci par des connexions de remplacement dont la longueur ne peut dépasser une valeur prédéterminée, et dans lequel les entrées et sorties des cellules de secours sont reliées à des pistes métalliques de secours dont la disposition sur le circuit est telle que tout point de ladite portion du circuit est distant au maximum de ladite valeur prédéterminée d'un point de ces pistes.

Selon un mode de réalisation de la présente invention, le circuit comprend plusieurs niveaux de métallisation, et les pistes de secours sont pour leur plus grande partie réalisées dans le niveau de métal le plus élevé possible.

Selon un mode de réalisation de la présente invention, les entrées d'un premier groupe de cellules de secours sont reliées à une masse du circuit et d'autres groupes de cellules de secours sont connectés en série avec le premier groupe par des pistes de secours disposées côte à côte en groupes de pistes de secours, de sorte qu'aucune entrée d'une cellule de secours n'est flottante.

Selon un mode de réalisation de la présente invention, les groupes de cellules de secours sont implantés sensiblement régulièrement le long des groupes de pistes de secours.

Selon un mode de réalisation de la présente invention, les groupes de pistes de secours sont disposés en zigzag sur la portion de circuit en une succession de lignes de même direction, s'étendant sur toute la largeur de la portion de circuit, ces lignes étant connectées entre elles à chaque extrémité par une portion de colonne perpendiculaire de longueur sensiblement égale à deux fois ladite valeur prédéterminée d'une connexion de remplacement.

Selon un mode de réalisation de la présente invention, un groupe de cellules de secours est disposé sensiblement à l'une des extrémités de chaque ligne de groupe de pistes de secours.

Selon un mode de réalisation de la présente invention, les entrées du premier groupe de cellules de secours sont reliées à la masse du circuit par de petits segments de pistes de secours.

Selon un mode de réalisation de la présente invention, les sorties d'une cellule de secours non connectées à une cellule de secours suivante sont reliées à de petits segments de pistes de secours laissés flottants.

Selon un mode de réalisation de la présente invention, un groupe de cellules de secours comporte des éléments standards tels qu'une porte NON ET, une bascule D, et une porte trois états.

La présente invention concerne également un procédé consistant à implanter dans une portion d'un circuit intégré au moins un groupe de cellules de secours destinées à être éventuellement reliées à des points de ladite portion de circuit intégré après la fabrication de celui-ci par des connexions de remplacement dont la longueur ne peut dépasser une valeur prédéterminée, et à relier les entrées et sorties des cellules de secours à des pistes métalliques dites pistes de secours dont la disposition sur le circuit est telle que tout point de ladite portion du circuit est distant au maximum de ladite valeur prédéterminée d'un point de ces pistes, lesdites pistes de secours étant réalisées dans le niveau de métal le plus élevé possible.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1A représente un groupe de cellules de secours selon l'état de la technique ;
la figure 1B représente un circuit rendu réparable en tout point selon l'état de la technique et expose le problème que vise à résoudre l'invention ;
la figure 2A représente un circuit rendu réparable en tout point selon un mode de réalisation de la présente invention ;
la figure 2B représente des groupes de cellules de secours utilisés dans un mode de réalisation de la présente invention ;
la figure 2C représente une portion de circuit intégré selon un mode de réalisation de la présente invention, comportant une erreur, avant correction ;
la figure 2D représente une portion de circuit intégré selon un mode de réalisation de la présente invention, comportant une erreur, après correction ;
la figure 2E illustre un autre mode de réalisation de l'invention ; et
la figure 2F illustre un autre mode de réalisation de l'invention.

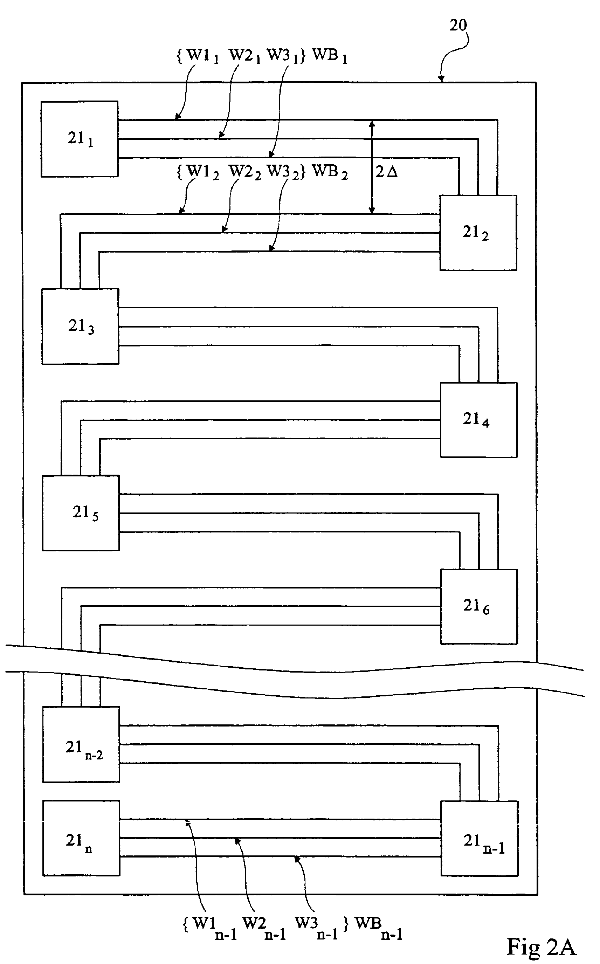

La figure 2A représente une vue de dessus extrêmement schématique d'un circuit intégré 20 dont les composants de base n'ont pas été représentés, réparable éventuellement en tout point selon la présente invention. Ce circuit comporte des groupes de cellules de secours $21_1$ à $21_n$ reliés entre eux par des groupes de "pis-

tes de secours" $WB_1$ à $WB_{n-1}$. Chaque groupe de pistes de secours $WB_i$, i étant compris entre 1 et n-1, est composé d'un certain nombre de pistes élémentaires, 3 dans cet exemple, désignées par $W1_i$, $W2_i$ et $W3_i$. Les groupes de pistes sont disposés en zigzag sur la portion de circuit de telle manière que la distance entre un point quelconque de la portion de circuit et les pistes de secours les plus proches soit au maximum égale à la distance maximale ($\Delta$) permise pour une réparation. Les "branches" du zigzag sont distantes de $2\Delta$ entre elles. Le mode de réalisation de la figure 2A comporte un groupe de cellules de secours par branche du zigzag ce qui permettra éventuellement d'effectuer une réparation à la hauteur de chaque branche de zigzag.

Si l'on prend comme exemple un circuit tel que représenté en figure 2A, de 10 mm par 10 mm, $\Delta$ étant égal à 400 $\mu$m, le nombre de groupes de cellules de secours implantées sera de 10 000/800 = 12,5 soit 13 groupes de secours. Si l'on considère qu'un groupe de cellules de secours est constitué d'environ quarante transistors, l'ensemble des groupes de cellules de secours dans ce mode de réalisation selon la présente invention représente 13 x 40 = 520 transistors. Une puce de 10 mm par 10 mm comporte classiquement un million de transistors, les cellules de secours représentent dans ce cas là environ 5 dix millièmes de la surface de la puce, ce qui est relativement négligeable.

Pour effectuer une correction entre deux bornes électriques situées dans le circuit intégré, on pratique un trou dans les couches supérieures du circuit jusqu'à chacune des bornes électriques que l'on veut connecter. Les trous achevés sont remplis de métal jusqu'au niveau de la surface du circuit afin de permettre un contact avec une connexion de remplacement. Moins un trou est profond et moins il est difficile à percer. De surcroît, moins un trou est profond et plus l'opération de remplissage du trou par du métal est facilement effectuée. Les opérations concernant les trous destinés à accéder aux bornes des composants du circuit intégré ne sont pas simplifiées par la présente invention. Par contre, les opérations concernant les trous destinés à accéder aux pistes de secours peuvent être facilitées. Les pistes de secours sont de préférence implantées dans le niveau de métallisation le plus proche de la surface du circuit intégré afin de limiter la profondeur des trous que l'on pratiquera pour les atteindre. Si l'implantation des pistes de secours sur le niveau de métallisation supérieur entre par endroits en conflit avec les pistes fonctionnelles du circuit implantées sur le même niveau, on doit prévoir en ces endroits un détournement local, de préférence de la piste fonctionnelle, par un niveau de métallisation inférieur. Ce type de détournement local d'une piste de circuit intégré depuis un niveau de métallisation vers un autre niveau de métallisation est connu de l'homme de l'art et ne sera pas détaillé ici.

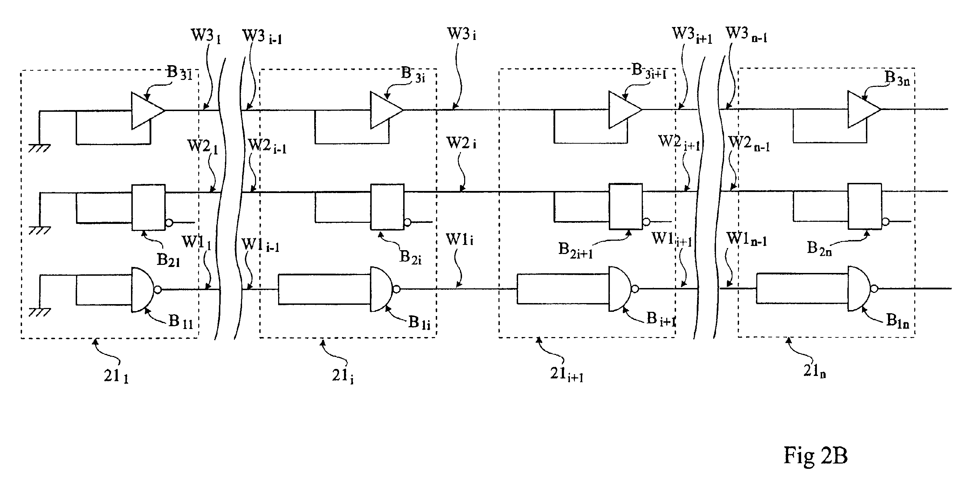

La figure 2B représente des groupes de cellules de secours $21_1$ à $21_n$ utilisables en figure 2A. Dans un mode de réalisation de l'invention, un groupe de cellules de secours $21_i$ est composé d'une porte NON ET, $B_{1i}$, d'une bascule D, $B_{2i}$, et d'une porte trois états, $B_{3i}$. Afin de limiter la puissance consommée par les cellules de secours si ces dernières ne sont pas utilisées, on connecte toutes les entrées des cellules de secours à un potentiel fixe. Les diverses cellules d'un même groupe de cellules de secours sont de préférence implantées côte à côte sur le circuit intégré. Les distances qui séparent les diverses cellules d'un même groupe de cellules de secours sont dans tous les cas très inférieures à la distance $\Delta$ susmentionnée.

Selon un mode de réalisation de la présente invention, les entrées des cellules du premier groupe de cellules de secours $21_1$ sont reliées à la masse par de petits segments de pistes de secours, et les sorties des cellules du dernier groupe de cellules de secours $21_n$ sont connectées à de petits segments de pistes de secours laissés flottants, afin de faciliter leur éventuelle connexion lors d'une réparation.

Selon un mode de réalisation de la présente invention, les deux entrées de la porte NON ET, $B_{1i}$ d'un groupe de cellules $21_i$ sont court-circuitées et reliées à la sortie de la porte NON ET $B_{1i-1}$ du groupe de cellules précédent $21_{i-1}$ par la piste de secours $W1_{i-1}$. Le court-circuit entre les deux entrées de la porte NON ET est de préférence réalisé par de petits segments de piste de secours afin de faciliter une éventuelle séparation des deux entrées lors d'une réparation.

Les deux entrées de la bascule D $B_{2i}$ d'un groupe de cellules $21_i$ sont court-circuitées et reliées à une sortie de la bascule D, $B_{2i-1}$ du groupe de cellules précédent $21_{i-1}$ par la piste de secours $W2_{i-1}$. Le court-circuit entre les deux entrées de la bascule D est de préférence réalisé par de petits segments de piste de secours afin de faciliter une éventuelle séparation des deux entrées lors d'une réparation ; la sortie non connectée de la bascule D est de préférence reliée à un petit segment de piste de secours, afin de faciliter sa connexion lors d'une réparation.

Les deux entrées de la porte trois états $B_{3i}$ d'un groupe de cellules $21_i$ sont court-circuitées et reliées à la sortie de la porte trois états $B_{3i-1}$ du groupe de cellules précédent $21_{i-1}$ par la piste de secours $W3_{i-1}$. Le court-circuit entre les deux entrées de la porte trois états est de préférence réalisé par de petits segments de piste de secours afin de faciliter une éventuelle séparation des deux entrées lors d'une réparation.

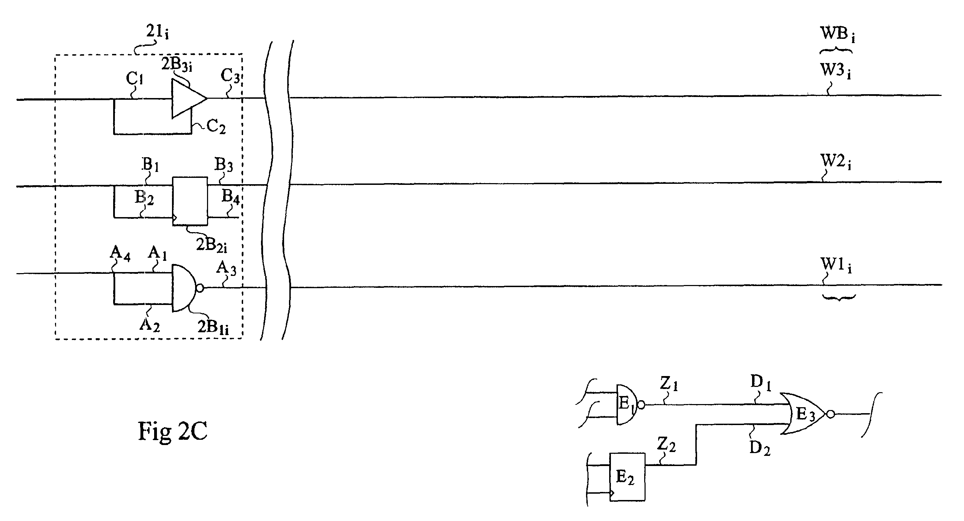

La figure 2C représente très schématiquement une portion d'un circuit intégré selon la présente invention. Elle représente un groupe de cellules de secours $21_i$ (comprenant une porte NON ET $B_{1i}$ ayant deux entrées A1 et A2 court-circuitées en A4 et une sortie A3, une bascule D $B_{2i}$ ayant deux entrées B1 et B2 et deux sorties B3 et B4, et une porte trois états $B_{3i}$ ayant deux entrées C1 et C2 et une sortie C3), un groupe de pistes de secours $WB_i$ (comprenant $W1_i$ connectée à A3, $W2_i$ connectée à B3 et $W3_i$ connectée à C3) et des composants élémentaires du circuit. Les composants élémentaires comprennent une porte NON ET E1 ayant une sortie Z1, une bascule D E2 ayant une sortie Z2 et une porte NON OU E3 ayant deux entrées D1 et D2. La sortie Z1 est connectée à l'entrée D1, la sortie Z2 est connectée à l'entrée D2. On désignera ci-après par Z1 et Z2 les signaux sur les sorties Z1 et Z2. On suppose que la portion de circuit intégré constituée des composants élémentaires EI, E2 et E3 présente une erreur logique. On suppose que cette erreur peut être corrigée en remplaçant sur l'entrée D2 du composant E3 le signal Z2 par un signal correspondant à Z1 NON ET Z2.

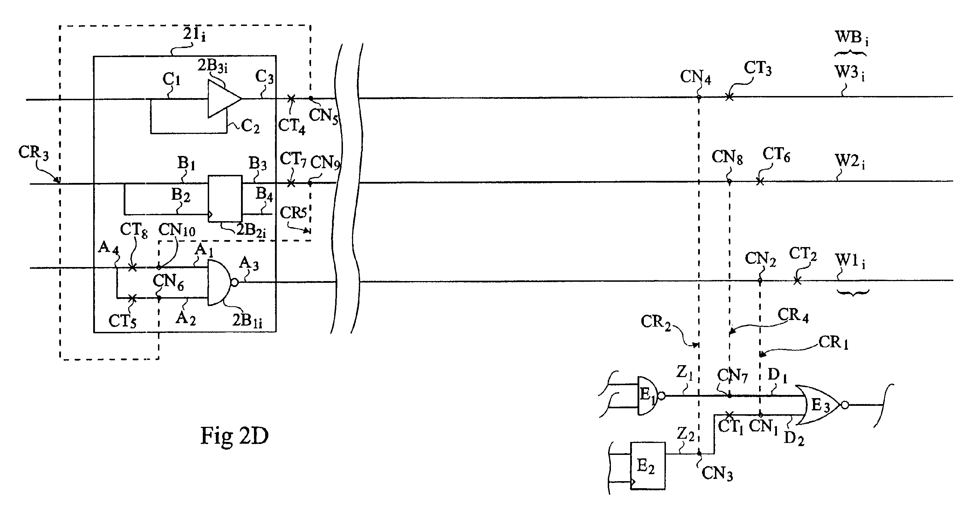

La figure 2D représente le circuit de la figure 2C après correction de l'erreur.

On a tout d'abord connecté la sortie A3 de la porte NON ET $B1_i$ à l'entrée D2 du composant E3 en utilisant la piste de secours $W1_i$. Une coupure de piste a été pratiquée en un point $CT_1$ de la piste reliant la sortie Z2 à l'entrée D2. Un trou a été pratiqué en un point $CN_1$ de la piste située entre le point $CT_1$ et l'entrée D2. Un trou a été pratiqué en un point $CN_2$ de $W1_i$ tel que la distance $CN_1$-$CN_2$ soit la plus courte possible. Une connexion de remplacement $CR_1$ a été établie entre les points $CN_1$ et $CN_2$. Une coupure de piste a été pratiquée en un point $CT_2$ de la piste $W1_i$ entre le point $CN_2$ et la cellule de secours suivante $B_{1i+1}$ (non représentée pour des motifs de clarté).

On a ensuite connecté la sortie Z2 du composant E2 à l'entrée A2 de la porte NON ET $B1_i$ en utilisant la piste de secours $W3_i$. Un trou a été pratiqué en un point $CN_3$ de la piste située entre la sortie Z2 et le point $CT_1$. Un trou a été pratiqué en un point $CN_4$ de $W3_i$ tel que la distance $CN_3$-$CN_4$ soit la plus courte possible. Une connexion de remplacement $CR_2$ a été établie entre les points $CN_3$ et $CN_4$. Une coupure de la piste W3i a été pratiquée en un point $CT_3$ entre le point $CN_4$ et la cellule de secours suivante $B_{3i+1}$ (non représentée pour des motifs de clarté). Un trou a été pratiqué en un point $CN_5$ de $W3_i$ entre le point $CN_4$ et la sortie C3 de la porte trois états $B3_i$ tel que le point $CN_5$ soit proche de la porte NON ET $B1_i$. Une coupure de piste a été pratiquée en un point $CT_4$ de la piste $W3_i$ entre le point $CN_5$ et la sortie C3. Un trou a été pratiqué en un point $CN_6$ de la piste située entre le point A4 et l'entrée A2. Une coupure de piste a été pratiquée en un point $CT_5$ de la piste située entre le point $CN_6$ et le point A4. Une connexion de remplacement $CR_3$ a été établie entre les points $CN_5$ et $CN_6$.

On a ensuite connecté la sortie Z1 du composant E1 à l'entrée A1 de la porte NON ET $B1_i$ en utilisant la piste de secours $W2_i$. Un trou a été pratiqué en un point $CN_7$ de la piste située entre la sortie Z1 et l'entrée D1. Un trou a été pratiqué en un point $CN_8$ de $W2_i$ tel que la distance $CN_7$-$CN_8$ soit la plus courte possible. Une connexion de remplacement $CR_4$ a été établie entre les points $CN_7$ et $CN_8$. Une coupure de la piste $W2_i$ a été pratiquée en un point $CT_6$ entre le point $CN_8$ et la cellule de secours suivante $B_{2i+1}$ (non représentée pour des motifs de clarté). Un trou a été pratiqué en un point $CN_9$ de $W2_i$ entre le point $CN_8$ et la sortie B3 de la bascule D $B2_i$

tel que le point $CN_9$ soit proche de la porte NON ET $B1_i$. Une coupure de la piste $W2_i$ a été pratiquée en un point $CT_7$ situé entre le point $CN_9$ et la sortie B3. Un trou a été pratiqué en un point $CN_{10}$ de la piste située entre le point A4 et l'entrée A1. Une coupure de piste a été pratiquée en un point $CT_8$ de la piste entre le point $CN_{10}$ et le point A4. Une connexion de remplacement $CR_5$ a été établie entre les points $CN_9$ et $CN_{10}$.

La borne d'entrée D2 du composant E3 reçoit à l'issue de cette correction un signal correspondant à Z1 NON ET Z2.

Bien entendu, la présente invention est susceptible de diverses variantes qui apparaîtront à l'homme de l'art.

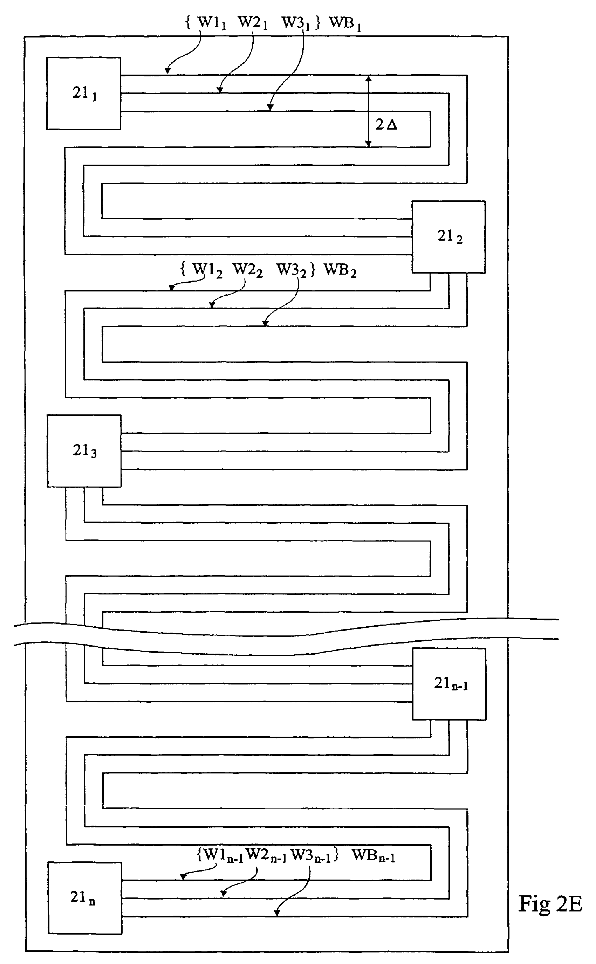

La figure 2E représente à titre de variante une vue de dessus extrêmement schématique d'un circuit intégré 20 dont les composants de base n'ont pas été représentés, réparable éventuellement en tout point selon la présente invention comportant des groupes de cellules de secours $21_1$ à $21_n$ reliés entre eux par des groupes de pistes de secours $WB_1$ à $WB_{n-1}$. Chaque groupe de pistes de secours $WB_i$, i étant compris entre 1 et n-1, est composé d'un certain nombre de pistes élémentaires, 3 dans cet exemple, désignées par $W1_i$, $W2_i$ et $W3_i$. Les groupes de pistes sont disposés en zigzag sur la portion de circuit de telle manière que la distance entre un point quelconque de la portion de circuit et les pistes de secours les plus proches soit au maximum égale à la distance maximale ($\Delta$) permise pour une réparation. Les branches du zigzag sont distantes de $2\Delta$ entre elles. Un groupe de cellules de secours $21_i$ est relié à un groupe de pistes de secours $WB_i$ correspondant à trois branches de zigzag. Cette variante permet d'effectuer un moins grand nombre de réparations sur le circuit 20 qu'avec le mode de réalisation de la figure 2A. Cependant, le nombre de cellules de secours étant moindre, la surface ajoutée au circuit par les cellules de secours sera réduite par rapport à la variante de la figure 2A.

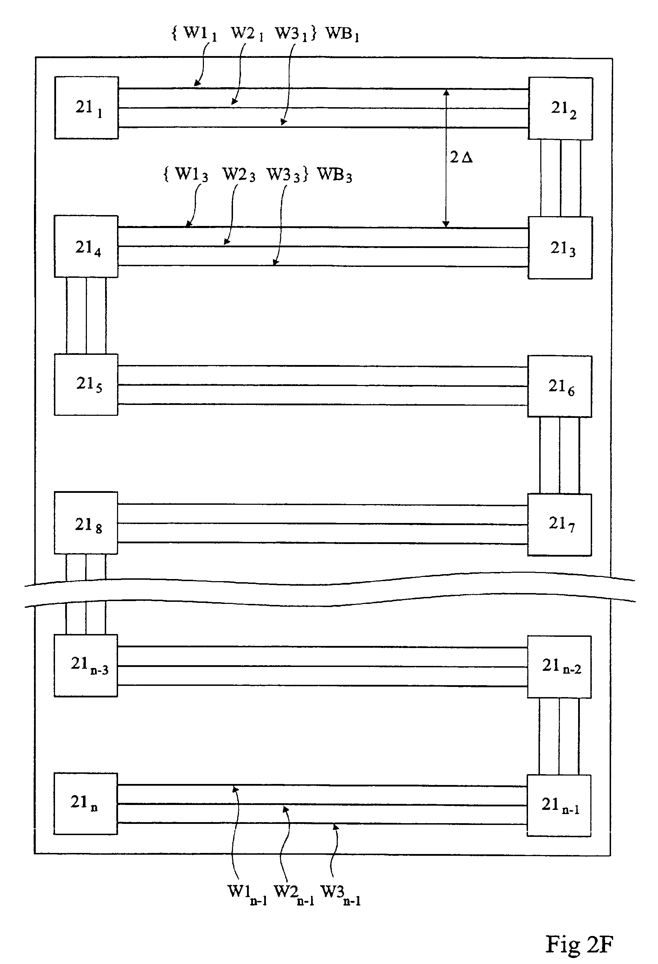

La figure 2F représente à titre de variante une vue de dessus extrêmement schématique d'un circuit intégré 20 dont les composants de base n'ont pas été représentés, réparable éventuellement en tout point selon la présente invention, comportant des groupes de cellules de secours $21_1$ à $21_n$ reliés entre eux par des groupes de pistes de secours $WB_1$ à $WB_{n-1}$. Chaque groupe de pistes de secours $WB_i$, i étant compris entre 1 et n-1, est composé d'un certain nombre de pistes élémentaires, 3 dans cet exemple, désignées par $W1_i$, $W2_i$ et $W3_i$. Les groupes de pistes sont disposés en zigzag sur la portion de circuit de telle manière que la distance entre un point quelconque de la portion de circuit et les pistes de secours les plus proches soit au maximum égale à la distance maximale ($\Delta$) permise pour une réparation. Les branches du zigzag sont distantes de $2\Delta$ entre elles. Deux groupes de cellules de secours $21_i$, $21_{i+1}$ sont reliés à chaque extrémité d'un groupe de pistes de secours $WB_i$ correspondant à une branche de zigzag. Le nombre de cellules de secours étant doublé par rapport à la variante de la figure 2A, la surface ajoutée au circuit par les cellules de secours sera doublée. Cependant, cette variante permet d'effectuer un plus grand nombre de réparations sur le circuit 20 qu'avec le mode de réalisation de la figure 2A.

A titre de variante, un groupe de cellules de secours peut employer un plus grand nombre, ou d'autres cellules standard que la porte NON ET, la bascule D et la porte trois états décrites ci-dessus ou employer un plus grand nombre de pistes de secours.

A titre de variante également, la répartition des pistes de secours sur la surface du circuit peut être différente de celle en zigzag et par exemple prendre une forme de spirale.

On a décrit jusqu'à présent le cas de pistes de secours recouvrant l'ensemble d'un circuit intégré, mais certaines portions d'un circuit intégré, comme par exemple des matrices de dispositifs mémoires ou des coeurs de microprocesseurs, ne se prêtent pas à des corrections de ce type et sont très peu susceptibles de présenter des erreurs. L'homme de l'art pourra adapter la description ci-dessus uniquement aux portions d'un circuit intégré susceptibles de présenter des erreurs et d'être réparées.

## Revendications

1. Circuit intégré dont une portion (20) au moins comprend au moins un groupe (21) de cellules de secours destinées à être éventuellement reliées à ladite portion (20) du circuit intégré après la fabrication de celui-ci par des connexions de remplacement (CR) dont la longueur ne peut dépasser une valeur prédéterminée ($\Delta$), **caractérisé en ce que** les entrées et sorties des cellules de secours sont reliées à des pistes métalliques de secours (W) dont la disposition sur le circuit est telle que tout point de ladite portion (20) du circuit est distant au maximum de ladite valeur prédéterminée ($\Delta$) d'un point de ces pistes (W).

2. Circuit intégré selon la revendication 1, comprenant plusieurs niveaux de métallisation, **caractérisé en ce que** les pistes de secours (W) sont réalisées dans le niveau de métal le plus élevé possible.

3. Circuit intégré selon la revendication 1, **caractérisé en ce que** les entrées d'un premier groupe de cellules de secours ($21_1$) sont reliées à une masse du circuit et **en ce que** d'autres groupes de cellules de secours ($21_2$ à $21_n$) sont connectés en série avec le premier groupe ($21_1$) par des pistes de secours ($W1_i$, $W2_i$, $W3_i$) disposées côte à côte en groupes de pistes de secours ($WB_i$), de sorte qu'aucune entrée d'une cellule de secours n'est flottante.

4. Circuit intégré selon la revendication 3, **caractérisé en ce que** les groupes de cellules de secours ($21_1$ à $21_n$) sont implantés régulièrement le long des groupes de pistes de secours ($WB_i$).

5. Circuit intégré selon la revendication 1, **caractérisé en ce que** des groupes de pistes de secours ($WB_i$) sont disposés en zigzag sur la portion de circuit (20) en une succession de lignes de même direction, s'étendant sur toute la largeur de la portion de circuit (20), ces lignes étant connectées entre elles à chaque extrémité par une portion de colonne perpendiculaire de longueur égale à deux fois ladite valeur prédéterminée ($\Delta$) d'une connexion de remplacement (CR).

6. Circuit intégré selon la revendication 5, **caractérisé en ce qu'**un groupe de cellules de secours ($21_i$) est disposé à l'une des extrémités de chaque ligne de groupe de pistes de secours ($WB_i$).

7. Circuit intégré selon la revendication 3, **caractérisé en ce que** les entrées du premier groupe de cellules de secours ($21_1$) sont reliées à la masse du circuit par des segments de pistes de secours.

8. Circuit intégré selon la revendication 3, **caractérisé en ce que** les sorties d'une cellule de secours non connectées à une cellule de secours suivante sont reliées à des segments de pistes de secours laissés flottants.

9. Circuit intégré selon la revendication 1, **caractérisé en ce qu'**un groupe de cellules de secours ($21_i$) comporte des éléments standards tels qu'une porte NON ET, une bascule D, et une porte trois états.

10. Procédé consistant à implanter dans une portion (20) d'un circuit intégré au moins un groupe (21) de cellules de secours destinées à être éventuellement reliées à des points de ladite portion (20) de circuit intégré après la fabrication de celui-ci par des connexions de remplacement (CR) dont la longueur ne peut dépasser une valeur prédéterminée ($\Delta$), **caractérisé en ce qu'**il comprend en outre l'étape consistant à relier les entrées et sorties des cellules de secours à des pistes métalliques de secours (W) dont la disposition sur le circuit est telle que tout point de ladite portion (20) du circuit est distant au maximum de ladite valeur prédéterminée ($\Delta$) d'un point de ces pistes (W), lesdites pistes de secours (W) étant réalisées dans le niveau de métal le plus élevé possible.

## Claims

1. An integrated circuit, at least one portion (20) of which includes at least one group (21) of standby cells connectable to said portion (20) of the integrated circuit after manufacturing thereof by replacement connections (CR), the length of which cannot exceed a predetermined value (Δ), **characterized in that** the inputs and outputs of the standby cells are connected to metal standby tracks (W) being disposed on the circuit such that any node of the circuit portion (20) is distant by at most said predetermined value (Δ) from any point on the tracks (W).

2. The integrated circuit of claim 1, including several metallization levels, **characterized in that** the standby tracks (W) are made in the highest possible metallization level.

3. The integrated circuit of claim 1, **characterized in that** the inputs of a first group of standby cells ($21_1$) are connected to a ground of the circuit and wherein other groups of standby cells ($21_2$ to $21_n$) are connected in series with the first group ($21_1$) by standby tracks ($W1_i$, $W2_i$, $W3_i$) arranged side by side in groups of standby tracks ($WB_i$), so that no input of a standby cell is floating.

4. The integrated circuit of claim 3, **characterized in that** the groups of standby cells ($21_1$ to $21_n$) are implanted regularly along the groups of standby tracks ($WB_i$).

5. The integrated circuit of claim 1, **characterized in that** the groups of standby tracks ($WB_i$) are arranged in a zigzag pattern on the circuit portion (20) in a succession of lines of same direction, extending across the entire width of the circuit portion (20), these lines being interconnected at each end by a portion of perpendicular column equal to twice the predetermined value (Δ) of a replacement connection (CR).

6. The integrated circuit of claim 5, **characterized in that** a group of standby cells ($21_i$) is arranged at one end of each line of a group of standby tracks ($WB_i$).

7. The integrated circuit of claim 3, **characterized in that** the inputs of the first group of standby cells ($21_1$) are connected to the circuit ground by segments of standby tracks.

8. The integrated circuit of claim 3, **characterized in that** the outputs of a standby cell unconnected to a following standby cell are connected to segments of standby tracks left floating.

9. The integrated circuit of claim 1, **characterized in that** a group of standby cells ($21_i$) includes standard elements such as a NAND gate, a D flip-flop, and a tri-state gate.

10. A method consisting of implanting in a portion (20) of an integrated circuit at least one group (21) of standby cells connectable to nodes of said integrated circuit portion (20) after the manufacturing thereof by replacement connections (CR), the length of which cannot exceed a predetermined value (Δ), **characterized in that** it further includes the step of connecting the inputs and outputs of the standby cells to metal standby tracks (W), being disposed on the circuit such that any node of said circuit portion (20) is distant at most by said predetermined value (Δ) from any point on the tracks (W), the standby tracks (W) being made in the highest possible metallization level.

**Patentansprüche**

1. Eine integrierte Schaltung, wobei mindestens ein Teil (20) derselben mindestens eine Gruppe (21) von "Standby"-Zellen aufweist, die mit dem erwähnten Teil (20) der integrierten Schaltung verbindbar sind, und zwar nach Herstellung derselben durch Ersatzverbindungen (CR), wobei die Länge derselben einen vorbestimmten Wert (Δ) nicht übersteigen kann, **dadurch gekennzeichnet, dass** die Eingänge und Ausgänge der Standby-Zellen mit Metall-Standby-Bahnen (W) verbunden sind, die auf der Schaltung derart angeordnet sind, dass jeder Knoten des Schaltungsteils (20) höchstens durch den erwähnten vorbestimmten Wert (Δ) von irgendeinem Punkt auf den Bahnen (W) beabstandet ist.

2. Integrierte Schaltung nach Anspruch 1, mit mehreren Metallisierungsebenen bzw. Metallisierungsniveaus, **dadurch gekennzeichnet, dass** die Standby-Bahnen (W) in der höchstmöglichen Metallisierungsebene ausgebildet sind.

3. Integrierte Schaltung nach Anspruch 1, **dadurch gekennzeichnet, dass** die Eingänge einer ersten Gruppe von Standby-Zellen ($21_1$) mit einer Erde der Schaltung verbunden sind, und wobei die anderen Gruppen der Standby-Zellen ($21_2$ bis $21_n$) in Serie mit der ersten Gruppe ($21_1$) durch Standby-Bahnen ($W1_i$, $W2_i$, $W3_i$) verbunden sind, und zwar angeordnet Seite an Seite in Gruppen der Standby-Tracks ($WB_i$) derart, dass kein Eingang einer Standby-Zelle "schwebend" (floating) bzw. nicht angeschlossen ist.

4. Integrierte Schaltung nach Anspruch 3, **dadurch gekennzeichnet, dass** die Gruppen der Standby-Zellen ($21_1$ bis $21_n$) regelmäßig entlang der Gruppen der Standby-Tracks ($WB_i$) implantiert sind.

5. Integrierte Schaltung nach Anspruch 1, **dadurch gekennzeichnet, dass** die Gruppen der Standby-Bahnen ($WB_i$) in einem Zick-Zack-Muster auf dem Schaltungsteil (20) angeordnet sind, und zwar in einer Aufeinanderfolge von Linien bzw. Zeilen der gleichen Richtung, und zwar sich über die gesamte Breite des Schaltungsteils (20) erstreckend, wobei diese Linien an jedem Ende miteinander verbunden sind, und zwar durch einen Teil der senkrechten Spalte gleich dem doppelten des vorbestimmten Werts ($\Delta$) einer Ersatzverbindung (CR).

**6.** Integrierte Schaltung nach Anspruch 5, **dadurch gekennzeichnet, dass** eine Gruppe von Standby-Zellen ($21_i$) an einem Ende jeder Linie oder Zeile einer Gruppe von Standby-Tracks ($WB_i$) angeordnet ist.

**7.** Integrierte Schaltung nach Anspruch 3, **dadurch gekennzeichnet, dass** die Eingänge der ersten Gruppe von Standby-Zellen ($21_1$) mit der Schaltungserde durch Segmente der Standby-Bahnen verbunden sind.

**8.** Integrierte Schaltung nach Anspruch 3, **dadurch gekennzeichnet, dass** die Ausgänge einer Standby-Zelle nicht verbunden mit einer darauffolgenden Standby-Zelle mit Segmenten von Standby-Zellen verbunden sind, die als schwebend (floating) gelassen wurden.

**9.** Integrierte Schaltung nach Anspruch 1, **dadurch gekennzeichnet, dass** eine Gruppe von Standby-Zellen ($21_i$) Standardelemente aufweist, wie beispielsweise ein NAND-Gatter, ein D-Flip-Flop und ein Tri-State- oder Drei-Zustands-Gatter.

**10.** Verfahren zum Implantieren von mindestens einer Gruppe (21) von Standby-Zellen in einem Teil (20) einer integrierten Schaltung mit Knoten des integrierten Schaltungsteils (20) nach der Herstellung desselben durch Ersatzverbindungen (CR) verbindbar sind, wobei die Standby-Zellen deren Länge einen vorbestimmten Wert ($\Delta$) nicht übersteigen kann, **dadurch gekennzeichnet, dass** das Verfahren ferner den Schritt des Verbindens der Eingänge und der Ausgänge der Standby-Zellen mit Metall-Standby-Bahnen (W) aufweist, die auf der Schaltung derart angeordnet sind, dass jeder Knoten des Schaltungsteils (20) höchstens durch den vorbestimmten Wert ($\Delta$) von irgendeinem Punkt auf den Bahnen (W) beabstandet ist, wobei die Standby-Bahnen (W) in dem höchstmöglichen Metallisierungsniveau vorgesehen sind.

Fig 1A

Fig 1B

Fig 2A

Fig 2B

Fig 2C

Fig 2D

13

$\{ W1_1 \quad W2_1 \quad W3_1 \} \, WB_1$

$21_1$

$2\Delta$

$21_2$

$\{ W1_2 \quad W2_2 \quad W3_2 \} \, WB_2$

$21_3$

$21_{n-1}$

$\{ W1_{n-1} \, W2_{n-1} \, W3_{n-1} \} \quad WB_{n-1}$

$21_n$

Fig 2E

$\{ W1_1 \quad W2_1 \quad W3_1 \} \, WB_1$

$21_1$

$21_2$

$2\Delta$

$\{ W1_3 \quad W2_3 \quad W3_3 \} \, WB_3$

$21_4$

$21_3$

$21_5$

$21_6$

$21_8$

$21_7$

$21_{n-3}$

$21_{n-2}$

$21_n$

$21_{n-1}$

$W1_{n-1} \quad W2_{n-1} \quad W3_{n-1}$

Fig 2F